# EUROPÄISCHE PATENTANMELDUNG

(11) **EP 4 498 052 A2**
(43) Veröffentlichungstag der Anmeldung: **29.01.2025**
(21) Anmeldenummer: 24219085.8
(22) Anmeldetag: 15.05.2020
(51) Int. Cl.: G01J 5/34

(54) **FERROELEKTRISCHER SENSOR**

(30) Priorität: 15.05.2019 DE 102019112771
(62) Teilanmeldung aus: 20729644.3
(71) Anmelder: TDK Electronics AG, 81671 München (DE)
(72) Erfinder: KAPPERT, Sandro, 03238 Finsterwalde (DE); SAX, Stefan, 8054 Graz (AT); PICHLER, Johann, 8614 Breitenau am Hochlantsch (AT)
(74) Vertreter: Epping - Hermann - Fischer

(57) **Zusammenfassung**

Es wird ein Sensor (1) beschrieben, der aus einer ersten Elektrode (3a), einer ferroelektrischen Schicht (2) und einer zweiten Elektrode (3b) besteht. Die zweiten Elektrode (3b) ist mit Masse verbunden ist und die ferroelektrische Schicht (2) ist zwischen der ersten und zweiten Elektrode (3a, 3b) angeordnet.

## Beschreibung

Die Erfindung betrifft einen ferroelektrischen Sensor.

Auf Grund der voranschreitenden Digitalisierung, die aktuell unter den Begriffen Industrie 4.0 oder Internet der Dinge angeschoben wird, werden Interaktionen zwischen Maschinen untereinander sowie mit Menschen immer alltäglicher. Eine von vielen Herausforderungen ist die Sicherheit von Menschen aber auch von Maschinen bei diesen Interaktionen zu erhöhen, indem Unfälle vermieden werden.

In diesem Zusammenhang werden zur Erkennung einer Gefahr und zur Vermeidung einer möglichen Kollision unterschiedliche Sensortypen in den immer intelligenteren Maschinen verbaut, die oft auf verschiedenen physikalischen Effekten beruhen. Auf der einen Seite können optische Sensoren oder Kameramodule dank der Reichweite ihres Detektionsbereichs zur frühzeitigen Erkennung einer möglichen Gefahr dienen. Ultraschallsensoren andererseits sind beispielsweise für Messungen in Nahdistanz geeignet und können so eine naheliegende Gefährdung erkennen. Im unmittelbaren Nahbereich, also wenn ein Kontakt zwischen einer Maschine und der Umgebung zustande kommt, kann zum Beispiel ein kapazitiver oder resistiver Sensor, wie eine Kontaktschutzleiste, zur Detektion einer Berührung genutzt werden.

Zumeist ist in teil- oder vollautonomen Maschinen eine Mehrzahl von unterschiedlichen Sensortypen verbaut, um einer Kollision vorzubeugen. Da die Sensoren unterschiedliche Bereiche abdecken, kann so ein ganzheitlicheres Bild der Umgebung erstellt werden.

Nichtsdestotrotz ist der Einbau von mehreren Sensoren unterschiedlicher Typen in eine Anwendung kostspielig. Darüber hinaus ist der Einsatz unterschiedlicher Sensortypen mit einem hohen technischen Aufwand verbunden. Unterschiedliche Sensortypen benötigen eine eigene Ansteuerungs- und Auswertungselektronik, womit das gesamte Sensorsystem verkompliziert und vergrößert wird. Außerdem muss auf jeden weiteren Sensortyp mindestens eine eigene stetige und spezifische Funktionsprüfung angewandt werden, die ständig den Sensor als auch die Elektronik überprüft, und das Gesamtsystem zusätzlich aufbläht.

Daher ist ein Sensor, der auf Basis von unterschiedlichen physikalischen Effekten funktioniert und verschiedene Sensortypen in sich vereinigt, wünschenswert.

Aufgabe der vorliegenden Erfindung ist es, einen Sensor, der auf Basis unterschiedlicher physikalischer Effekte ein Messsignal erzeugt, bereitzustellen.

Die vorliegende Aufgabe wird durch den Sensor nach Anspruch 1 gelöst. Weitere vorteilhafte Ausführungen und potentielle Anordnungen sind den weiteren Ansprüchen zu entnehmen.

Es wird ein Sensor beschrieben, der aus einer ersten Elektrode, einer ferroelektrischen Schicht und einer zweiten Elektrode besteht. Die ferroelektrische Schicht ist zwischen den zwei Elektroden angeordnet und die zweite Elektrode ist mit Masse verbunden.

Ein Messsignal kann als Spannungsänderung zwischen den Elektroden abgegriffen werden. Die Masse kann auf Erdpotential liegen.

Die ferroelektrische Schicht kann hierbei aus einem Material, das im elektrischen Feld ferroelektrische Eigenschaften zeigt, bestehen. Vorzugsweise kann die Schicht aus einem ferroelektrischen Material mit piezoelektrischen Eigenschaften, besonders bevorzugt aus einem ferroelektrischen Material mit pyroelektrischen Eigenschaften bestehen.

Da alle pyroelektrischen Materialien ebenso piezoelektrische Materialien sind, ist die funktionelle Schicht zwischen den Elektroden nicht nur sensitiv gegenüber Temperaturänderungen sondern auch gegenüber jeglicher Verformung des Sensors auf Grund des piezoelektrischen Effekts. Da eine der Elektroden geerdet ist, kann eine starke Annäherung oder Berührung der Elektrode die Kapazität zwischen der Elektrode und den sich nähernden Objekt ändern und kann ebenfalls zu einer Spannungsänderung zwischen den Elektroden führen. Auf diese Art können drei verschiedene physikalische Effekte, ein kapazitiver, ein piezoelektrischer und ein pyroelektrischer, innerhalb eines Sensors ausgenutzt werden.

Den pyroelektrische, piezoelektrische und kapazitiven Effekt innerhalb eines Sensor zu vereinigen, ist besonders vorteilhaft, da die drei Effekte zur Erfassung unterschiedlicher Ereignisse geeignet sind. Mit dem pyroelektrischen Effekt lassen sich Temperaturänderungen, die aus der Umgebung stammen, registrieren. Es lassen sich somit berührungslos Temperaturänderungen, die beispielweise von der Körperwärme eines Menschen oder der Wärmeerzeugung einer Maschine stammen, aus der Ferne feststellen. Der kapazitive Effekt kann ebenfalls zur berührungslosen Detektion verwendet werden, allerdings ist dafür eine starke Annäherung an den Sensor nötig. Vorteilhaft ist jedoch, dass die Annäherung über den kapazitiven Effekt auch dann detektiert werden kann, wenn eine Detektion des pyroelektrischen Effekts aufgrund der Annäherung eines auf gleicher Temperatur befindlichen Objekts kein oder nur ein geringes Sensorsignal ergibt. Komplementär zum pyroelektrischen Effekt kann der piezoelektrische bzw. kapazitive Effekt ausgenutzt werden, um eine Berührung des Sensors mit einem anderen Objekt zu erfassen. Zusätzlich können der piezoelektrische bzw. der kapazitive Effekt eine verbesserte Detektion ermöglichen, da bei gleichem Sensor, durch den pyroelektrischen Effekt ein um den Faktor 10 bis 100 schwächeres Spannungssignal erzeugt wird als der piezoelektrische bzw. kapazitive Effekt. Der piezoelektrische Effekt unterscheidet sich vom kapazitiven Effekt jedoch dahingehend, dass für eine Spannungsänderung an den Elektroden beim piezoelektrischen Effekt eine aktive räumliche Verformung der piezoelektrischen Schicht stattfinden muss, wogegen beim kapazitiven Effekt bereits eine ruhende Berührung zu einer Spannungsänderung führt. Folglich wird durch den piezoelektrischen Effekt beispielsweise bei einem räumlich nach außen stehenden Sensor, der flexibel ist und der durch ein sich näherndes Objekt verbogen wird, durch die Verkrümmung der piezoelektrischen Schicht eine Spannungsänderung hervorgerufen. Die Spannungsänderung ist für eine Messung des Abstands zum nähernden Objekt geeignet, da die Höhe der Spannungsänderung vom Grad der Verkrümmung abhängt. Ruht die verformte piezoelektrische Schicht hingegen, oder kommt es zu keiner Verformung, entsteht keine Spannungsänderung auf Grund des piezoelektrischen Effekts. In diesem Fall kommt der kapazitive Effekt zum Tragen, der auch ohne Verformung der Schicht zu einer Spannungsänderung zwischen den Elektroden führt, falls die geerdete Elektrode eine Berührung erfährt.

Indem der Sensor verschiedene physikalischer Effekte als Basis für die Detektion heranziehen kann, kann die Anzahl an unterschiedlichen Sensortypen, die in einer Anwendung verbaut werden müssen, reduziert werden. Darüber hinaus kann die benötigte Ansteuerungs- und Auswerteelektronik, da sie nicht für jeden Sensortyp separat bereit gestellt werden muss, vereinfacht und verschlankt werden. Werden darüber hinaus in den Sensoren verschiedene physikalische Effekte genutzt, die komplementäre Detektionsbereiche abdecken, kann eine genauere Übersicht der Umgebung gegeben werden und so eine Annäherung eines Objekts festgestellt werden.

Die gemessenen Änderungen des elektrischen Signals kann eine Änderung des Signal-Zeit-Verlauf und/oder der Amplitude und/oder der Zeitskala und/oder der zeitlichen Dynamik und/oder der Polarität umfassen. Somit kann es möglich sein, die gesamte Dynamik des elektrischen Signals zu erfassen.

Das elektrische Signal kann eine Spannung und/oder eine Ladung und/oder eine Kapazität und/oder eine Polarität umfassen. Somit kann das elektrische Signal unabhängig von der Art der Messung sein bzw. es können Messungen basierend auf unterschiedlichen Messprinzipien vorgenommen werden.

Die ferroelektrische Schicht kann ein Polymer, eine Keramik oder eine Polymer-Keramik-Matrix aufweisen, wobei als Polymer Polyvinylidenfluorid (PVDF) und seine Co-Polymere und als Keramik Blei-Zirkonat-Titanat (PZT)oder BaTiO₃ verwendet werden kann. Die vorgenannten Beispiele sind hierbei ferroelektrische Materialien, die pyroelektrische Eigenschaften aufweisen sowie industriellen Ansprüchen genügen. PVDF ist ein pyroelektrisch Kunststoff, der biegsam ist und deshalb besonders geeignet ist. Geeignete Verfahren zu Auftragung von PVDF auf der ersten Elektrode können Spin Coating, Siebdruck oder Ink-Jet Druck sein. PZT und BaTiO₃ hingegen ist eine pyroelektrische Keramik, die nur als dünne Schicht flexibel ist. Die PZT Keramik kann zusätzlich mit Na, Ca oder La dotiert sein, um die elektrischen Eigenschaften anzupassen. Handelt es sich bei der pyroelektrischen Schicht um PZT, BaTiO₃ oder eine andere blei-freie oder blei-haltige Keramik kann diese über ein Dünnschichtverfahren, wie etwa CVD, PVD, über eine Kombination aus Sol-Gel-Verfahren mit Spincoating oder über Siebdruck auf der ersten Elektrode aufgetragen werden.

Sowohl die erste als auch die zweite Elektrode können aus einem im UV-Vis-Bereich und/oder bevorzugt im IR-Bereich, transparenten und/oder thermisch leitfähigen Material sein. Somit kann sichergestellt werden, dass infrarote Wärmestrahlung direkt die ferroelektrische Schicht erreicht und daher die Sensibilität des Sensors erhöht. Geeignet Materialien können zum Beispiel ITO, PEDOT:PSS, Graphit, metallische Nanodrähte, Carbon-nano-tubes oder Graphen sein.

Daneben können die Elektroden aus einer oder mehreren Lagen von Metallen wie Al, Cr, Ni, Ag, Cu, oder einer Mischung, einer intermetallischen Verbindung sowie einer Legierung dieser Elemente bestehen oder diese Elemente aufweisen. Bevorzugt handelt es sich hierbei um Sputterschichten. Im Fall von Sputterschichten können auch mehrere Lagen unterschiedlicher Metallen übereinander gesputtert werden, beispielsweise Cr/Ni/Ag. Durch die Auswahl der jeweiligen Metalle kann die Kontaktierung, beispielsweise durch Lötung, des Sensors verbessert werden, da eine bessere Haftung ermöglicht werden kann. Elektroden aus Metall weisen eine hohe elektrische und thermische Leitfähigkeit auf, wodurch die Sensibilität des Sensors nicht stark beeinträchtigt wird.

Darüber hinaus kann der Sensor weitere erste Elektroden, zweite Elektroden und ferroelektrische Schichten aufweisen, wobei die ferroelektrischen Schichten zwischen den ersten und zweiten Elektroden angeordnet sind. Indem der Sensor als Mehrschichtbauteil umgesetzt wird, können mehrere funktionelle ferroelektrische Schichten hintereinander gereiht werden und sowohl die Sensibilität als auch die Genauigkeit des Sensors erhöht werden.

Eine Anordnung auf oder zwischen Elementen kann entweder eine unmittelbare Anordnung, bei der die angeordneten Elemente einander berühren und direkt aufeinander liegen, oder eine mittelbare Anordnung sein, bei der zwischen den aufeinander angeordneten Elementen weitere Elemente sein können. Die Elektroden sind in jeden Fall unmittelbar auf eine ferroelektrische Schicht angeordnet, so dass sie diese berühren und einen elektrischen Kontakt herstellen.

Es ist möglich bei einem Mehrschichtbauteil die einzelnen funktionellen Schichten separat zu kontaktieren. Hierbei werden die ersten Elektroden mit jeweils separaten ersten Kontaktelementen und die zweiten Elektroden jeweils mit separaten zweiten Kontaktelementen elektrisch kontaktiert. Hierdurch kann für die jeweilige funktionelle Schicht ein separates Sensorsignal ausgewertet werden, wobei es zusätzlich möglich ist für die einzelnen funktionellen Schichten unterschiedliche Arten von Sensorsignalen abzugreifen.

Alternativ dazu können bei einem Mehrschichtbauteil alle ersten Elektroden mit demselben ersten elektrischen Kontaktelement und alle zweiten Elektroden mit demselben zweiten elektrischen Kontaktelement elektrisch kontaktiert werden. Somit werden alle ersten Elektroden miteinander parallel geschaltet und alle zweiten Elektroden werden miteinander parallel geschalten. Ein elektrisches Signal kann zwischen den Kontaktelementen abgegriffen werden. Hierdurch kann im Sinne einer Signaladdition der Sensorsignale aus den Signalen der einzelnen funktionellen Schichten ein verstärktes Signal zur Auswertung herangezogen werden.

Überdies kann die erste Elektrode im Inneren des Sensors angeordnet sein, die ferroelektrische Schicht die erste Elektrode ummanteln und die zweite Elektrode die ferroelektrische Schicht ummanteln. Eine solche Ausführungsform kann bevorzugt zylinderförmig oder plattenförmig ausgebildet sein. Das Schichten im Sensor können so angeordnet sein, dass die Ausdehnung des Sensors in einer Richtung, die senkrecht zu den Schichten des Sensors ist, kurz gegenüber der Ausdehnung des Sensors entlang der Schichten ist. Diese Ausführungsform ermöglicht unzählige weitere Anwendungen für einen Sensor nach der vorliegenden Erfindung. Außerdem ist eine zylinderförmige Geometrie des Sensors hilfreich, um die Sensibilität gegenüber Verformungen zu erhöhen. Ein ummantelter Sensor kann auch in einem Endlosprozess, analog zur Draht bzw. Kabelfertigung, hergestellt werden, womit eine preisgünstige Produktion ermöglicht werden kann.

Gemäß einer möglichen Verwendung des Begriffs "ummantelt" kann eine Schicht auch dann als von einer anderen Schicht ummantelt angesehen werden, wenn die ummantelnde Schicht die darunter liegende Schicht nicht perfekt umhüllt, sondern zu einem großen Teil. Werden Schnittbilder quer zu den Schichten aufgenommen, kann eine Schicht als ummantelt gelten, wenn mehr als 90%, 95%, 99% oder 99,9 % der Schnittbilder keine Fehlstellen in der ummantelnden Schicht, die sich durch die gesamte Schichtdicke ausdehnen, aufweisen. Bei der Herstellung der Schichten können unvermeidlich Fehlstellen oder Risse in den Schichten entstehen, die eine perfekte Umhüllung erschweren können. Auch im Betrieb können durch mechanische Beanspruchung Risse in den Schichten des Sensors entstehen, die jedoch die Funktion des Sensors nur bedingt stören. Eine Schicht oder ein Element, das von einer Schicht ummantelt wird, kann alternativ von dieser vollständig eingeschlossen sein.

Außerdem kann der Sensor eine Isolationsschicht aufweisen, auf der die erste Elektrode oder die zweite Elektrode angeordnet sein kann, wobei der Sensor so aufgerollt sein kann, dass die Isolationsschicht auf einer Innenseite liegt. Die Innenseite weist in einem aufgerollten Sensor hin zu einer Mittelachse des Sensors und weg von einer Mantelfläche des Sensors. Das Aufrollen führt zu Elektroden, die im Querschnitt durch den Sensor spiralförmig sind, und zu einer ferroelektrischen Schicht, die im Querschnitt durch den Sensor spiralförmig ist und sandwichsartig zwischen den ebenfalls spiralförmigen Elektroden verläuft. Eine der Elektroden, die nicht unmittelbar auf der Isolationsschicht angeordnet ist, bildet somit eine Mantelfläche des aufgerollten Sensors.

Ein aufgerollter Sensor kann bevorzugt zylinderförmig ausgebildet sein. Indem der Sensor aufgerollt wird, ist es möglich mit Herstellungsprozessen für flächige Schichten auch zylinderförmige Sensoren zu produzieren. Die Isolationsschicht dient in erste Linie der elektrischen Isolation der Elektroden, die sonst beim Aufrollen kurz schließen würden. Wird der Sensor mehrmals aufgerollt, entsteht ein Mehrschichtbauteil, wobei der Sensor jedoch nur eine erste und eine zweite Elektrode aufweist. Das elektrische Verhalten unterscheidet sich deutlich von einer ummantelten Ausführungsform mit mehreren gestapelten Schichten, da sich beim aufgerollten Sensor eine einzige Kapazität bildet, die einer parallelen Verschaltung von Kondensatoren entspricht, wogegen bei einer ummantelten Ausführungsform mit mehreren gestapelten Schichten die Kapazität, die zwischen den Elektroden gebildet wird, einer seriellen Verschaltung von Kondensatoren entspricht. Für vergleichbare Schichtanzahlen, Materialien und Ausmessungen ergeben sich für einen aufgerollten Sensor somit eine höhere Kapazität, womit der kapazitive Effekt im Sensor deutlich ausgeprägter ist.

Ferner kann der Sensor ein Trägermaterial aufweisen. Je nach Anwendungsbereich kann das Trägermaterial inelastisch oder elastisch sein. Ein inelastisches Trägermaterial kann die mechanische Stabilität des Sensors erhöhen. Insbesondere für den Transport und den Einbau des Bauteils kann eine hohe mechanische Stabilität nützlich sein, um Beschädigungen zu vermeiden. Auch für bestimmte Anwendungen kann eine Anordnung auf einem Trägermaterial aus Glas, Beton oder Stahl erforderlich sein, obwohl der piezoelektrische Effekt dadurch vermindert würde. Elastische Materialien, die als Trägermaterial in Frage kommen, können unter anderem Gummi, ein Kunststoff oder ein Textil, wie beispielsweise Polyester, sein.

Die erste Elektrode oder die zweite Elektrode kann auf dem Trägermaterial angeordnet sein. Es ist zu beachten, dass eine ausreichende Haftung zwischen der Elektrode und dem Trägermaterial benötigt wird. Für eine ausreichende Haftung wird durch eine geeignete Auswahl der Materialien für das Trägermaterial und der Elektrode gesorgt. Auch eine Oberflächenbehandlung des Trägermaterials, etwa ein Aufrauen, kann zu einer Verbesserung der Haftung zwischen Trägermaterial und Elektrode ausgeführt werden.

Weiterhin kann der Sensor eine Isolationsschicht aufweisen, auf der die erste Elektrode oder die zweite Elektrode angeordnet ist, wobei der Sensor so aufgerollt ist, dass die Isolationsschicht auf dem Trägermaterial angeordnet ist. Somit kann über die Wahl des Trägermaterials die mechanische Stabilität eines aufgerollten Sensors kontrolliert werden. Da als Trägermaterial unterschiedliche Materialien und selbst Gegenstände in Frage kommen, eröffnen sich durch eine solche Anordnung eine Vielzahl an möglichen Anwendungsfeldern für den Sensor. Indem der Sensor aufgerollt wird, wird der kapazitive Effekt des Sensors verstärkt.

In einer weiteren Ausführungsform kann ein Trägermaterial im Inneren des Sensors angeordnet sein, wobei die erste Elektrode das Trägermaterial, die ferroelektrische Schicht die erste Elektrode und die zweite Elektrode die ferroelektrische Schicht ummantelt. Durch die Wahl des Trägermaterials kann der Sensor je nach Anwendung steifer oder flexibler gestaltet und optimiert werden. Auch diese Ausführungsform kann vorzugsweise zylinderförmig oder plattenförmig ausgebildet sein. Ferner ist es auch möglich einen auf diese Art gestalteten Sensor in einem Endlosprozess und damit preisgünstig herzustellen.

Ein Sensor, mit einer ersten Elektrode im Inneren, kann weitere erste, zweite Elektroden und ferroelektrische Schichten aufweisen, wobei die ersten und zweiten Elektroden radial alternierend angeordnet sind und je eine ferroelektrische Schicht zwischen einer der ersten Elektroden und einer der zweiten Elektroden angeordnet ist. Da so mehrere funktionelle ferroelektrische Schichten hintereinander gereiht werden, kann sowohl die Sensibilität als auch die Genauigkeit des Sensors erhöht werden.

Ein ummantelter, aber auch ein gerollter, Sensor, können ganz unabhängig davon, ob er ein Trägermaterial aufweist, weitere erste Elektroden, zweite Elektroden und ferroelektrische Schichten aufweisen, wobei je eine ferroelektrische Schicht zwischen einer der ersten Elektroden und einer der zweiten Elektroden angeordnet ist. Somit wird analog zu einem gestapelten Vielschichtbauteil die Signalstärke und daher die Sensibilität als auch die Genauigkeit des Sensors erhöht.

Das Trägermaterial für einen ummantelten oder gerollten Sensor kann beispielsweise eine Textilfaser sein. Dieser Sensor kann beispielsweise in Kleidungen, Bezügen oder Teppichen eingewebt werden. Künstliche Textilfasern, etwa aus Polyester, eignen sich für diesen Einsatz hervorragend. Aber auch natürliche Faser können benutzt werden, falls sie den Herstellungsprozess überstehen.

Ferner kann das Trägermaterial auch eine Glasfaser sein. Diese kann dazu genutzt werden einen Systemzustand, beispielsweise ob eine unmittelbare Berührung der Sensors stattfindet oder einer Annäherung einer Wärmequelle vorhanden ist, durch eine Farbausgabe bzw. Farbänderung nach außen zu vermitteln.

Auf einen Teil einer Manteloberfläche der Glasfaser kann eine optisch reaktive Sensorschicht aufgebracht sein. Diese reaktive Schicht kann zum Beispiel auf den ph-Wert oder O₂-Gehalt in der Umgebung mit einer Farbänderung reagieren. Mit Hilfe der Glasfaser kann diese Farbänderung gemessen werden und der Sensor kann um eine weitere sensorische Dimension erweitert werden. Auch ein Einsatz von Faser-Bragg-Gittern als Trägermaterial ist möglich und kann den Informationsoutput des Sensors steigern.

Es kann vorteilhaft sein, den Sensor zylindrisch auszubilden. Somit ist der Sensor radial symmetrisch und eine Messsignal, das beispielsweise durch eine Deformation des Sensor entsteht, richtungsunabhängig. Auch eine plattenförmige Ausbildung des Sensors ist möglich. Bei einer Plattenform kann eine Breite und eine Länge mindestens zehnmal so groß sind wie eine Höhe. Dies erlaubt Herstellungsprozesse für flächige Schichten für die Produktion des Sensors zu verwenden.

Weiterhin kann der Sensor mindestens ein mechanisches Verstärkerelement aufweisen. Die mechanischen Verstärkerelemente können beispielsweise haar-, oder borstenförmige Vorsprünge sein, die eine mechanische Berührung auf den Sensor übertragen. Auf diese Art kann der Wirkungsbereich, der einen piezoelektrischen Effekt aufgrund von Verformung und dem kapazitiven Effekt hervorruft, vergrößert werden. Die mechanischen Verstärkerelemente können aus einem Verbundwerkstoff oder aus Kunstoffen wie PET, Duroplast oder Teflon bestehen.

Das mechanische Verstärkerelement kann aus der ersten und/oder zweiten Elektrode ausgebildet sein. Die Herstellung des mechanischen Verstärkerelements kann in den Herstellungsprozess der Elektroden miteingebunden werden, womit der Sensor günstig und unkompliziert um mechanische Verstärkerelemente erweitert werden kann.

Weist der Sensor ein Trägermaterial auf, kann das mindestens eine mechanische Verstärkerelement auch aus dem Trägermaterial ausgebildet sein. Insbesondere bei zylindrischen Sensoren, egal ob ummantelt oder gerollt, kann ein im Inneren angeordnetes Trägermaterial aus dem Sensor herausragen und so auf einfache Weise ein mechanisches Verstärkerelemente bilden.

Alternativ kann das mindestens eine mechanische Verstärkerelement aus der ersten Elektrode und dem Trägermaterial ausgebildet sein. Auch diese Ausführungsform ist für zylindrische Sensoren besonders geeignet. In diesem Fall ragt das Trägermaterial und eine auf dem Trägermaterial angeordnete Elektrode aus dem Sensor raus. Somit wird nicht nur der Wirkungsbereich des piezoelektrischen Effekts, sondern auch der Wirkungsbereich des kapazitiven Effekts des Sensors erweitert.

Die einzelnen Schichten des Sensors, d.h. die ferroelektrischen Schichten sowie die ersten und zweiten Elektroden können jeweils dünner als 50 µm sein. Indem der Sensor äußerst dünn gestaltet wird, kann er flexibel und biegbar sein, was insbesondere bei Messungen basierend auf den piezoelektrischen Effekt vorteilhaft ist. Eine dünne Ausgestaltung, vor allem auch der pyroelektrischen Schicht, ermöglicht eine niedrige thermische Masse des Sensors und verbessert somit die Ansprechzeit und die Sensitivität des Sensors gegenüber Temperaturänderungen.

Eine vorteilhafte Anordnung kann den oben beschriebenen Sensor und eine Auswerteelektronik aufweisen. Die Auswerteelektronik kann dafür ausgestaltet sein, eine in der ferroelektrischen Schicht erzeugte Spannung zu messen und Änderungen der Spannung durch einen piezoelektrischen Effekt, einen pyroelektrischen Effekt und einen kapazitiven Effekt zu erkennen. Die Auswerteelektronik sollte dafür ausgelegt sein aus dem Signal-Zeit-Verlauf anhand der Amplitude, der Zeitskala, der zeitlichen Dynamik und der Polarität das Messsignal einem oder mehreren der physikalischen Effekte zuzuordnen. Anhand der Zuordnung der Spannungsänderung zu einem oder mehreren der physikalischen Effekte kann die Auswertungselektronik erkennen, ob ein Objekt sich dem Sensor nähert, oder ob ein Objekt den Sensor berührt.

In einer weiteren vorteilhaften Anordnung können mehrere Sensoren in einer Matrix angeordnet sein. Durch die Anordnung der Sensoren in einer Matrix können ortsaufgelöste Messungen durchgeführt und somit auch Bewegungen nachvollzogen werden. Es können beispielsweise planare Sensoren auf einem Substrat angeordnet werden oder zylindrische Sensoren können so angeordnet werden, dass sie teppichartig von einem Substrat hervortreten.

Der Sensor kann in einem Roboter integriert sein. Roboter, gerade auch autonome Roboter, wie etwa Reinigungsroboter, Rasenmäherroboter, Lieferroboter oder Transportroboter profitieren von einem vereinfachten Sensor, der eine Annäherung an den Roboter feststellen kann. Wird eine Annäherung vom Sensor registriert kann der Roboter entsprechend handeln, indem er die Geschwindigkeit verlangsamt, stehen bleibt oder einem Hindernis ausweicht.

Kollaborativen Systeme, die Sensoren nach der vorliegenden Erfindung aufweisen, profitieren ebenfalls von der Möglichkeit eine Annäherung zu registrieren. In kollaborativen Systemen ergeben sich zahlreiche Interaktionen von Maschinen mit Menschen sowie mit anderen Maschinen, die eine Gefahr für Kollisionen darstellen. Eine zuverlässige Detektion von der Umgebung mit dem Sensor minimiert die Unfallgefahr und verspricht einen sicheren Arbeitsablauf.

Der Sensor nach der vorliegenden Erfindung kann auch in automatischen Türen, vor allem in automatischen Drehtüren oder Aufzugtüren integriert sein. Falls der Sensor eine Annäherung einer Person erfasst, kann sich die Tür öffnen, ein Schließen der Tür verhindert werden oder die Drehgeschwindigkeit einer Drehtür verlangsamt werden, um eine Kollision oder das Einklemmen der annähernden Person zu verhindern.

Ein weiterer Aspekt betrifft ein Verfahren zur Herstellung des oben beschriebenen Sensors, wobei die ferroelektrische Schicht über ein Dünnschichtverfahren, beispielsweise CVD oder PVD, oder über eine Kombination aus einem Sol-Gel-Verfahren mit Spincoating auf der ersten Elektrode aufgetragen wird.

Der Sensor weist insbesondere die folgenden Aspekte auf:
1. Ein Sensor aufweisend:
   - eine erste Elektrode,
   - eine ferroelektrische Schicht,
   - eine zweite Elektrode,
   wobei die zweite Elektrode mit Masse verbunden ist und die ferroelektrische Schicht zwischen der ersten und zweiten Elektrode angeordnet ist.
2. Ein Sensor nach dem vorherigen Aspekt, wobei die ferroelektrischen Schichten ein Polymer, eine Keramik oder eine Polymer-Keramik-Matrix aufweisen.
3. Ein Sensor nach einem der vorherigen Aspekte, wobei die erste und/oder die zweite Elektrode ein transparentes und thermisch sowie elektrisch leitfähiges Material aufweisen.
4. Ein Sensor nach einem der vorherigen Aspekte, wobei die erste und/oder die zweite Elektrode ein oder mehrere Metalle aufweisen, wobei das eine Metall oder die mehreren Metalle Al, Cr, Ni, Ag, Cu, Fe sowie eine Mischung oder einer Legierung dieser Elemente aufweisen.
5. Ein Sensor nach einem der vorherigen Aspekte, wobei die erste und/oder die zweite Elektrode eine im UV-Vis-Bereich und/oder IR-Bereich transparente leitfähige Schicht aufweisen.
6. Ein Sensor nach einem der vorherigen Aspekte, wobei die erste und/oder die zweite Elektrode ITO, PEDOT:PSS, Silber, Nanowires, Graphit, Carbon-nano-tubes oder Graphen aufweisen.
7. Ein Sensor nach einem der vorherigen Aspekte, wobei der Sensor weitere erste Elektroden, zweite Elektroden und ferroelektrische Schichten aufweist, und wobei die ferroelektrischen Schichten zwischen den ersten und zweiten Elektroden angeordnet sind.
8. Ein Sensor nach Aspekt 7, wobei alle ersten Elektroden miteinander parallel geschaltet sind und alle zweiten Elektroden miteinander parallel geschalten sind,
   wobei ein elektrisches Signal zwischen den ersten und zweiten Elektroden ausgelesen wird.
9. Ein Sensor nach Aspekt 7, wobei die einzelnen ferroelektrischen Schichten separat kontaktiert sind und für jede der ferroelektrischen Schichten zwischen je einer der ersten Elektroden und einer der zweiten Elektroden ein elektrisches Signal ausgelesen wird.
10. Ein Sensor nach einem der vorherigen Aspekte, wobei die erste Elektrode im Inneren des Sensors angeordnet ist, die ferroelektrische Schicht die erste Elektrode ummantelt und die zweite Elektrode die ferroelektrische Schicht ummantelt.
11. Ein Sensor nach einem der Aspekte 1 bis 9, wobei der Sensor eine Isolationsschicht aufweist, auf der die erste Elektrode oder zweite Elektrode angeordnet ist, und wobei der Sensor so aufgerollt ist, dass die Isolationsschicht auf einer Innenseite liegt.
12. Ein Sensor nach einem der Aspekte 1 bis 9, wobei der Sensor ein Trägermaterial aufweist.
13. Ein Sensor nach dem vorherigen Aspekt, wobei auf dem Trägermaterial die erste Elektrode oder zweite Elektrode angeordnet ist.
14. Ein Sensor nach Aspekt 12, wobei der Sensor eine Isolationsschicht aufweist, auf der die erste Elektrode oder zweite Elektrode angeordnet ist, und wobei der Sensor so aufgerollt ist, dass die Isolationsschicht auf dem Trägermaterial angeordnet ist.
15. Ein Sensor nach Aspekt 12, wobei das Trägermaterial im Inneren des Sensors angeordnet ist, und die erste Elektrode das Trägermaterial ummantelt, die ferroelektrische Schicht die erste Elektrode ummantelt und die zweite Elektrode die ferroelektrische Schicht ummantelt.
16. Ein Sensor nach einem der Aspekte 10 oder 15, wobei weitere erste und zweite Elektroden sowie weitere ferroelektrische Schichten die zweite Elektrode ummanteln, wobei erste und zweite Elektroden radial alternierend angeordnet sind, und wobei je eine der ferroelektrischen Schichten zwischen einer der ersten Elektroden und einer der zweiten Elektroden angeordnet ist.
17. Ein Sensor nach einem der Aspekte 12 bis 16, wobei das Trägermaterial eine Textilfaser oder eine Glasfaser ist.
18. Ein Sensor nach dem vorherigen Aspekt, wobei auf einem Teil einer Manteloberfläche der Glasfaser eine optisch reaktive Sensorschicht aufgebracht ist.
19. Ein Sensor nach einem der vorherigen Aspekte, wobei der Sensor zylindrisch ausgebildet ist oder wobei der Sensor plattenförmig ausgebildet ist.
20. Ein Sensor nach einem der vorherigen Aspekte, wobei der Sensor mindestens ein mechanisches Verstärkerelement aufweist.
21. Ein Sensor nach dem vorherigen Aspekt, wobei das mindestens eine mechanische Verstärkerelement aus der ersten und/oder zweiten Elektrode ausgebildet ist.
22. Ein Sensor nach Aspekt 12 und Aspekt 20, wobei das mindestens eine mechanische Verstärkerelement aus dem Trägermaterial ausgebildet ist.
23. Ein Sensor nach Aspekt 12 und Aspekt 20, wobei das mindestens eine mechanische Verstärkerelement aus der ersten Elektrode und dem Trägermaterial ausgebildet ist.
24. Ein Sensor nach einem der vorherigen Aspekte, wobei die ferroelektrische Schicht und/oder die ersten Elektroden und/oder zweiten Elektroden dünner als 50 µm sind.
25. Ein Sensor nach einem der vorherigen Aspekte, wobei die ferroelektrischen Schichten ein piezoelektrisches und/oder pyroelektrisches Material aufweisen.
26. Eine Anordnung, aufweisend:
   - mindestens eine Auswerteelektronik,
   - mindestens einen Sensor nach einem der vorherigen Aspekte, wobei die Auswerteelektronik dazu ausgestaltet ist, ein durch den Sensor erzeugtes elektrisches Signal zu messen und durch Änderungen des elektrischen Signals einen piezoelektrischen Effekt, einen pyroelektrischen Effekt und einen kapazitiven Effekt zu erkennen.
27. Eine Anordnung nach dem vorherigen Aspekt, wobei die Auswerteelektronik dazu ausgestaltet ist, anhand der gemessenen Änderungen des elektrischen Signals zu erkennen, ob ein Objekt sich dem Sensor nähert, oder ob ein Objekt den Sensor berührt.
28. Eine Anordnung nach Aspekt 26 oder 27, wobei die gemessenen Änderungen des elektrischen Signals eine Änderung des Signal-Zeit-Verlauf und/oder der Amplitude und/oder der Zeitskala und/oder der zeitlichen Dynamik und/oder der Polarität umfassen.
29. Eine Anordnung nach einem der Aspekte 26 bis 28, wobei das elektrische Signal eine Spannung und/oder eine Ladung und/oder eine Kapazität und/oder eine Polarität umfasst.
30. Eine Anordnung nach einem der Aspekte 26 bis 29, ferner aufweisend mehrere Sensoren nach einem der Aspekte 1 bis 24, wobei die Sensoren in einer Matrix angeordnet sind.
31. Ein Roboter, wobei der Roboter einen Sensor nach einem der Aspekte 1 bis 25 aufweist.
32. Ein kollaboratives System, wobei das kollaborative System einen Sensor nach einem der Aspekte 1 bis 25 aufweist.
33. Eine automatische Tür, wobei die automatische Tür einen Sensor nach einem der Aspekte 1 bis 25 aufweist.
34. Verfahren zur Herstellung eines Sensors gemäß einem der Aspekte 1 bis 25, wobei die ferroelektrische Schicht über ein Dünnschichtverfahren, beispielsweise CVD oder PVD, über eine
Kombination aus einem Sol-Gel-Verfahren mit Spincoating, oder über Siebdruck auf der ersten Elektrode aufgetragen wird.

Im Folgenden wird die Erfindung anhand von schematischen Darstellungen näher beschrieben.
Figur 1 zeigt eine schematische Querschnittsansicht eines ersten Ausführungsbeispiels der vorliegenden Erfindung.
Figur 2 zeigt eine schematische Anordnung mit einem Sensor und der Auswerteelektronik.
Figur 3 zeigt eine weitere schematische Anordnung mit einem Sensor und der Auswerteelektronik.
Figur 4 zeigt ein Strukturdiagramm der Auswertung.
Figur 5 zeigt eine schematische Messkurve eines Sensors.
Figur 6 zeigt eine Messkurve der Spannungsänderung auf Grund eines pyroelektrischen Effekts.
Figur 7 zeigt eine Messkurve der Spannungsänderung auf Grund eines piezoelektrischen Effekts.
Figur 8 zeigt eine Messkurve der Spannungsänderung auf Grund eines kapazitiven Effekts.
Figur 9 zeigt eine schematische Querschnittsansicht eines mehrschichtig ausgeführten Sensors, wobei das elektrische Signal verstärkt wird.
Figur 10 zeigt eine schematische Querschnittsansicht eines mehrschichtig ausgeführten Sensors, wobei mehrere einzelne elektrische Signale ausgelesen werden.
Figur 11 zeigt eine schematische Querschnittsansicht eines plattenförmigen und ummantelten Ausführungsbeispiels, wobei eine erste Elektrode im Inneren des Sensors angeordnet ist.
Figur 12 zeigt eine schematische Querschnittsansicht eines plattenförmig und ummantelten Ausführungsbeispiel, wobei ein Trägermaterial im Inneren des Sensors angeordnet ist.
Figur 13 zeigt eine schematische Querschnittansicht eines weiteren Ausführungsbeispiels, wobei Verstärkerelemente auf der zweiten Elektrode angeordnet sind.
Figur 14 zeigt eine schematische Querschnittsansicht eines zylindrischen Ausführungsbeispiels, wobei Verstärkerelemente auf dem Trägermaterial und der ersten Elektrode angeordnet sind.
Figur 15 zeigt eine schematische Querschnittsansicht eines vierten zylindrischen Ausführungsbeispiels, wobei das verlängerte Trägermaterial mit der ersten Elektrode als Verstärkerelement dient.
Figur 16 zeigt eine schematische Querschnittsansicht eines zylindrischen Ausführungsbeispiels.
Figur 17 zeigt eine schematische Querschnittsansicht eines mehrschichtigen zylindrischen Ausführungsbeispiels.
Figur 18 zeigt eine schematische Querschnittsansicht eines zylindrischen Ausführungsbeispiels, wobei eine optisch reaktive Schicht auf dem Trägermaterial angeordnet ist.
Figur 19 zeigt eine schematische Querschnittsansicht eines Ausführungsbeispiels mit Isolationsschicht, wobei der Sensor aufgerollt ist.
Figur 20 zeigt eine schematische Querschnittsansicht eines Ausführungsbeispiels mit Isolationsschicht, wobei der Sensor um ein Trägermaterial aufgerollt ist.
Figur 21 zeigt einen Roboter mit möglichen Sensorpositionen.
Figur 22 zeigt ein kollaboratives System mit möglichen Sensorpositionen.
Figur 23 zeigt ein eine automatische Dreht mit möglichen Sensorpositionen.
Figur 24 zeigt eine automatische Aufzugtür mit möglichen Sensorpositionen.

Gleiche Elemente, ähnliche oder augenscheinlich gleiche Elemente sind in den Figuren mit den gleichen Bezugszeichen versehen. Die Figuren und die Größenverhältnisse in den Figuren sind nicht maßstabsgetreu.

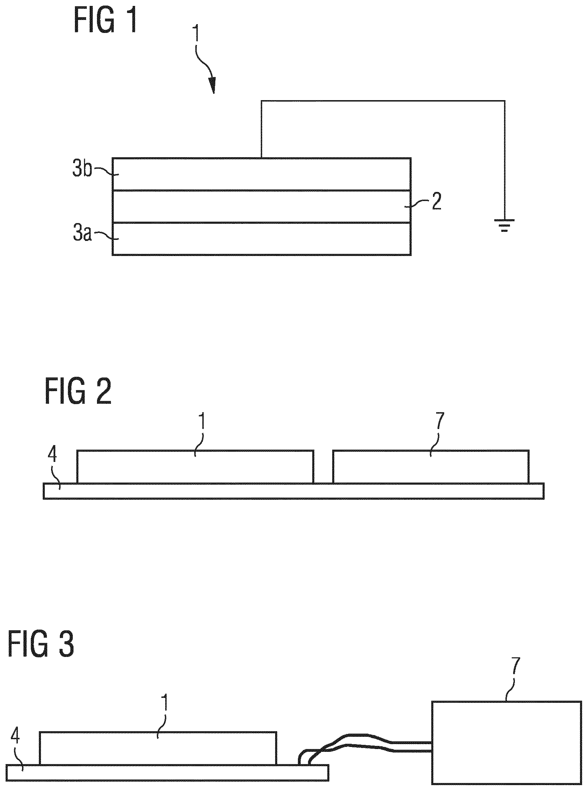

In Figur 1 wird eine schematische Querschnittsansicht eines Sensors 1 nach der vorliegenden Erfindung gezeigt. Über einer ersten Elektrode 3a ist eine ferroelektrische Schicht 2 angeordnet und darüber ist eine zweite Elektrode 3b angeordnet. Die zweite Elektrode 3b ist elektrisch kontaktiert und mit Masse verbunden.

Die ferroelektrische Schicht kann hierbei aus einem Material, das im elektrischen Feld ferroelektrische Eigenschaften zeigt, bestehen. Vorzugsweise kann die Schicht aus einem ferroelektrischen Material mit piezoelektrischen Eigenschaften, besonders bevorzugt aus einem ferroelektrischen Material mit pyroelektrischen Eigenschaften bestehen.

Die Elektroden 3a, 3b sind elektrisch kontaktiert (nicht gezeigt) und eine Spannungsänderung kann beispielsweise zwischen den Elektroden 3a, 3b kann als Messsignal ausgelesen werden. Die pyroelektrischen Schicht 2, die ebenso piezoelektrisch ist, reagiert sowohl gegenüber Temperaturänderungen als auch gegenüber Verformung mit einer Ladungstrennung, die an den Elektroden 3a, 3b zu einer Spannungsänderung führt. Infolge der Erdung der zweiten Elektrode 3b, resultiert aus der Kapazitätsänderung zwischen der zweiten Elektrode 3b und einem sich nähernden Objekt, bei einer starken Annäherung oder einer Berührung, eine Spannungsänderung zwischen den Elektroden 3a, 3b. Der Sensor 1 der vorliegenden Erfindung nutzt drei verschiedene physikalische Effekte, den kapazitiven, den piezoelektrischen und den pyroelektrischen, aus, um unterschiedliche Detektionsbereiche abzudecken.

Dank des pyroelektrischen Effekts können Temperaturänderungen, die je nach Wärmequelle einige Meter entfernt sein können, detektiert werden. Der kapazitive Effekt kann ebenfalls zur berührungslosen Detektion verwendet werden, allerdings ist dafür eine starke Annäherung eines zu detektierenden Objekts auf einige Zentimeter an den Sensor 1 nötig. Der piezoelektrische und der kapazitive Effekt können dafür genutzt werden, eine Berührung des Sensors 1 mit einem anderen Objekt festzustellen. Der piezoelektrische Effekt unterscheidet sich vom kapazitiven Effekt jedoch dahingehend, dass für eine Spannungsänderung an den Elektroden 3a, 3b beim piezoelektrischen Effekt eine aktive räumliche Verformung der pyroelektrischen Schicht 2 stattfinden muss, wohingegen beim kapazitiven Effekt bereits eine ruhende Berührung zu einer Spannungsänderung führt.

Die ferroelektrische Schicht 2 weist PVDF oder PZT auf. Beide Materialien sind pyroelektrisch. PVDF ist als pyroelektrischer Kunststoff, der elastisch ist, besonders geeignet, da die ferroelektrische Schicht 2 leicht verformt werden kann und somit eine Spannungsänderung durch den piezoelektrischen Effekt hervorgerufen werden kann. Eine ferroelektrische Schicht 2 aus PVDF kann etwa durch Spin Coating, Siebdruck oder Ink-Jet Druck aufgebracht werden. PZT hingegen ist eine pyroelektrische Keramik, die als sehr dünne Schicht Flexibilität aufzeigt. Ein Dotierung der PZT Keramik mit Na, Ca oder La, um die elektrischen Eigenschaften anzupassen, ist möglich. PZT oder andere pyroelektrische Keramiken können mit Hilfe eines Dünnschichtverfahrens, wie etwa CSD oder PVD, aufgebracht werden. PVDF hat gegenüber Keramiken, wie PZT, den Vorteil, dass es auch ohne Probleme auf einer größeren Fläche aufgetragen werden kann, da Keramiken als großflächige Schicht auf Grund von innerer Spannung und Druck platzen kann.

Vorzugsweise sind die ersten und zweiten Elektroden 3a, 3b aus einem transparenten sowie leitfähigen Material, wie beispielsweise ITO, PEDOT:PSS, Silber, Graphit, metallische Nanodrähte, Carbon-nano-tubes oder Graphen. Materialien, die eine Transparenz im UV-Vis-Bereich und/oder im IR-Bereich aufweisen und/oder mit eine gute thermische Leitfähigkeit aufzeigen, sind besonders gut als Elektrode 3a, 3b geeignet. Dies erleichtert den Wärmeeintrag in die ferroelektrische Schicht 2, da infrarote Wärmestrahlung direkt auf die ferroelektrische Schicht 2 trifft. Somit wird die Sensibilität des Sensors 1, vor allem bezüglich des pyroelektrischen Effekts, erhöht. Die Elektroden 3a, 3b können auch aus Metallen wie Al, Cr, Ni, Ag, Cu, einer Mischung von Metallen, einer intermetallischen Verbindung oder einer Legierung bestehen. Da Metalle eine hohe elektrische und thermische Leitfähigkeit aufweisen, sind diese ebenfalls als Elektrodenmaterial geeignet.

Die Schichten des Sensors 1 sind jeweils dünner als 50 um, womit der gesamte Sensor 1 flexibel und biegbar ist. Somit kann der Sensor 1 leicht verformt werden, was zu einer Spannungsänderung zwischen den ersten und zweiten Elektroden 3a, 3b auf Grund des piezoelektrischen Effekts führt. Da der Sensor 1 äußerst dünn ist, besitzt er eine niedrige thermische Masse, womit die Ansprechzeit verkürzt wird und die Sensitivität des Sensors 1 gegenüber Temperaturänderungen erhöht wird.

Der Sensor 1 muss nicht, wie in Figur 1 gezeigt, mit nur einer pyroelektrischen Schicht 2 gestaltet sein, sondern kann mit mehreren pyroelektrischen Schichten 2 und mehreren ersten und zweiten Elektroden 3a, 3b in einer Mehrschichtbauweise realisiert werden. Hierbei werden die pyroelektrischen Schichten 2 immer zwischen erste und zweite Elektrode 3a, 3b angeordnet, wobei die ersten und zweiten Elektroden 3a, 3b sich in Stapelrichtung alternierend abwechseln. Durch die Umsetzung des Sensors 1 als Mehrschichtbauteil kann sowohl die Sensitivität als auch die Genauigkeit des Sensors 1 erhöht werden.

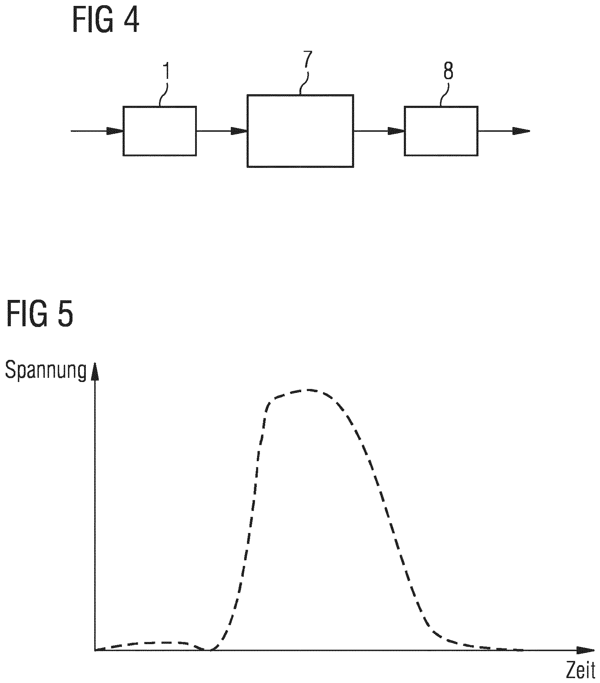

Das Messsignal, das als Spannungsänderung an den ersten und zweiten Elektroden 3a, 3b abgegriffen wird, wird an eine Auswertelektronik weitergeleitet. Die Auswerteelektronik 7 kann hierbei auf dasselbe Trägermaterial 4 wie der Sensor 1, wie in Figur 2 dargestellt, oder nicht auf dasselbe Trägermaterial 4, wie in Figur 3 dargestellt, angeordnet sein. Entweder ist die Auswerteelektronik 7 direkt am Sensor 1 oder über das Trägermaterial 4, wie in Figur 3 gezeigt, kontaktiert. Entsteht am Sensor 1 durch ein Messereignis eine Spannungsänderung wird diese Spannungsänderung analog an die Auswerteelektronik 7, wie in Figur 4 zu sehen, weitergeleitet. Die Auswerteelektronik 7 weist unter anderem Signalverstärker, Komparatoren sowie Mikroprozessoren auf und ist dazu ausgelegt eine Messkurve dem piezoelektrischen, pyroelektrischen oder kapazitiven Effekt zuzuordnen. Anschließend wird das Signal digital an eine digitale Auswertung 8 gesendet, die wiederum ein Ausgangssignal ausgibt.

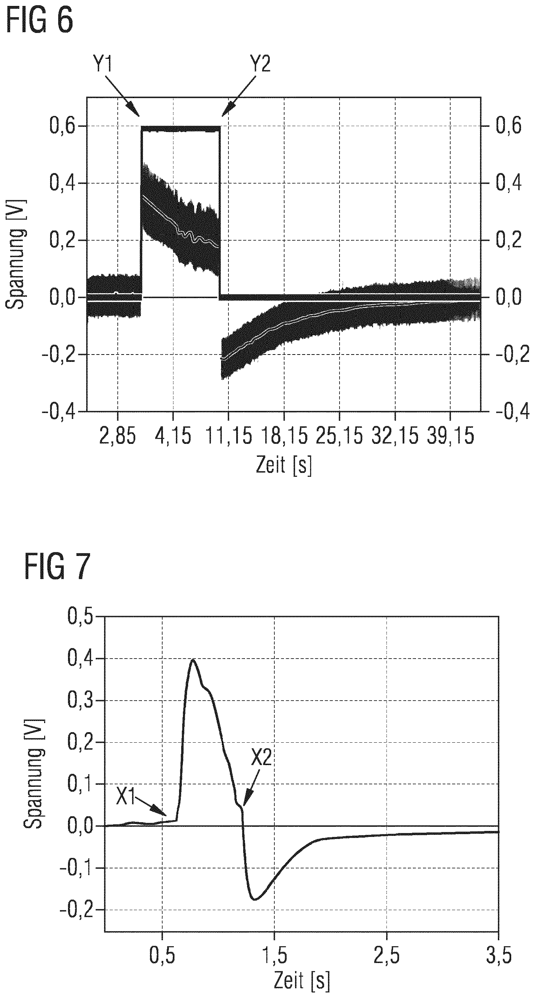

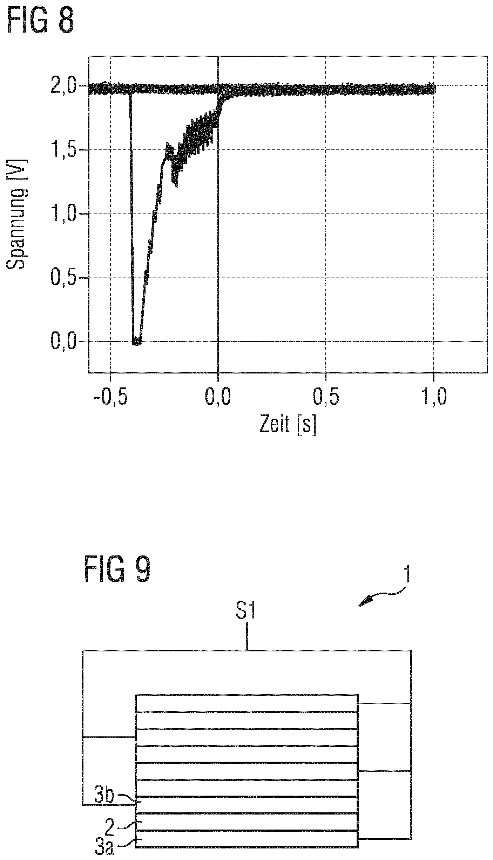

In Figur 5 wird eine Beispielkurve gezeigt, die eine Spannungsänderung nach einer mechanischen oder thermischen Anregung des Sensors 1 aufzeigt. In dem Diagramm in Figur 5 wird, wie auch in den Diagrammen in Figur 6, 7 und 8, die Spannung gegenüber der Zeit aufgetragen. In Figur 6 wird einer Spannungsänderung gezeigt, die aus einem rein pyroelektrischen Effekt herrührt. An der Stelle Y1 wird eine Wärmequelle eingeschaltet und an der Stelle Y2 wiederum ausgeschaltet. In Figur 7 wird eine Messkurve dargestellt, die nur aus dem piezoelektrischen Effekt stammt. An der Stelle X1 wird eine Verformung durch einen Druckaufschlag herbeigeführt und an der Stelle X2 wird der Druckaufschlag wieder entfernt. Die Messkurve in Figur 8 zeigt eine Spannungsänderung am Sensor 1, der ausschließlich von einem kapazitiven Effekt stammt.

Ein Ausschlag der Messkurve auf Grund des pyroelektrischen Effekts ist beispielsweise langsamer als ein Ausschlag auf Grund des piezoelektrischen oder kapazitiven Effekts, wie ein Vergleich von Figur 6 mit den Figuren 7 und 8 zeigt. Außerdem kann der Kurvenverlauf beim pyroelektrischen Effekt, wie in Figur 6 zu sehen, Unstetigkeiten aufweisen, wenn eine Wärmequelle auf den Sensor 1 wirkt (Y1) oder anschließend abgeschaltet bzw. abgeschirmt wird (Y2). In diesen Fall wirkt das Abschalten der Wärmequelle als negative Temperaturdifferenz, wodurch die Polarität geändert wird und die Messkurve einen abrupten Vorzeichenwechsel vollzieht.

Beim piezoelektrischen Effekt kann ebenfalls ein Vorzeichenwechsel, wie in Figur 7 gezeigt, in der Messkurve, beispielsweise beim Loslassen (X2) des Sensors 1 nach dem er vorher verformt wurde (X1), geschehen. Jedoch ist der Kurvenverlauf im Gegensatz zum pyroelektrischen Effekt stetig und kann sehr viel schneller sein. Die Amplituden- bzw., Spannungsänderung ist beim pyroelektrischen Effekt typischerweise um den Faktor 10 bis 100 geringer als beim piezoelektrischen Effekt, was jedoch beim Vergleich von Figur 6 mit Figur 7 nicht ersichtlich ist, da die Kurven vorher entsprechend verstärkt wurden.

Der kapazitive Effekt kann andererseits keinen Vorzeichenwechsel in der Messkurve hervorrufen, und ein Ausschlag kann zeitlich schneller sein als ein Ausschlag auf Grund des piezoelektrischen Effekts, wie in Figur 8 zu sehen ist. Die beiden Messkurven in Figur 8 wurden mit einem Sensor 1 aufgenommen, bei dem im einem Fall die zweite Elektrode 3b mit Masse verbunden war und im anderen Fall nicht. Da keine Spannungsänderung bei der Messkurve ohne Masseanschluss der zweiten Elektrode 3b auftritt, lässt sich feststellen, dass die Spannungsänderung allein auf den kapazitiven Effekt zurückzuführen ist und kein piezoelektrisch Effekt, der unabhängig vom Masseanschluss der zweiten Elektrode 3b zu einer Spannungsänderung führen würde, auftritt. Durch Analyse der Messkurve auf diese unterschiedlichen Charakteristika kann die Auswerteelektronik 7 eine Zuordnung zu den physikalischen Effekten vornehmen.

Liegt der Sensor 1, wie in Figur 9 gezeigt, als Mehrschichtbauteil vor, können alle ersten Elektroden 3a mit demselben ersten elektrischen Kontaktelement und alle zweiten Elektroden mit demselben zweiten elektrischen Kontaktelement elektrisch kontaktiert werden. Somit werden die einzelnen ersten und zweiten Elektroden parallel geschalten. Hierdurch kann im Sinne einer Signaladdition die elektrischen Signale S der einzelnen funktionellen Schichten ein verstärktes elektrisches Signal S1 zur Auswertung herangezogen werden.

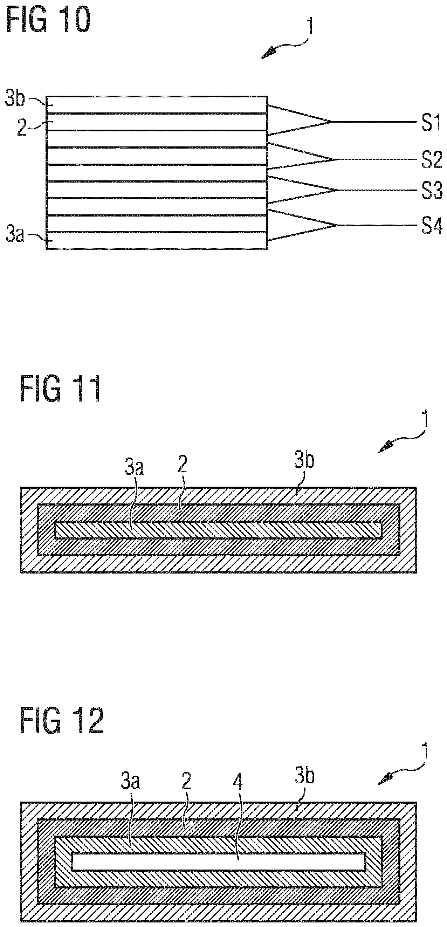

In der alternativen Ausführungsform, wie in Figur 10 gezeigt, sind einzelne funktionellen Schichten separat kontaktiert. Hierbei werden die ersten Elektroden mit jeweils separaten ersten Kontaktelementen und die zweiten Elektroden jeweils mit separaten zweiten Kontaktelementen elektrisch kontaktiert. Hierdurch kann für die jeweilige funktionelle Schicht ein separates elektrisches Signal (S1, S2, S3, S4) ausgewertet werden, wobei es zusätzlich möglich ist für die einzelnen funktionellen Schichten unterschiedliche Arten von Sensorsignalen abzugreifen und nach den physikalischen Effekten zu unterscheiden.

In Figur 11 wird eine schematische Querschnittsansicht eines plattenförmigen und ummantelten Ausführungsbeispiels gezeigt, bei dem die erste Elektrode 3a im Inneren des Sensors 1 angeordnet ist, wobei die ferroelektrische Schicht 2 die erste Elektrode 3a ummantelt und die zweite Elektrode wiederum die ferroelektrische Schicht 2 ummantelt. Ein solcher Sensor 1 kann Schicht für Schicht mit Hilfe von geeigneten Herstellungsprozessen für flächige Schichten, wie etwa Siebdruck, aufgebaut werden. Es kann hierbei vorteilhaft sein, innere Schichten mit einer flächenmäßig größeren Schicht zu überdrucken, um eine Ummantelung zu realisieren. Bei der Herstellung der Ummantelung kann es jedoch auch opportun sein, erst auf einer Seite der inneren Schicht eine darauf angeordnete Schicht aufzutragen und das Bauteil im Anschluss zu wenden und auf der anderen Seite dieselbe Schichtart aufzutragen. Vor dem Wenden wird die aufgetragene Schicht getrocknet.

Figur 12 zeigt eine zu Figur 11 ähnliche schematische Querschnittsansicht eines plattenförmigen und ummantelten Ausführungsbeispiels eine Sensors 1, wobei in diesem Fall ein Trägermaterial 4 im Inneren des Sensors angeordnet ist. Auch dieses Ausführungsbeispiel kann, wie in Figur 11, mit einem Herstellungsprozess für flächige Schichten erzeugt werden, wobei die Schichten entweder nacheinander aufgetragen werden oder aber indem das Bauteil für jede ummantelnde Schicht gewendet wird.

Das Trägermaterial 4 kann sowohl inelastisch als auch elastisch sein. Durch ein inelastisches Trägermaterial 4, wie einem Substrat, wird die Stabilität des Sensors 1 erhöht. Für ausgewählte Anwendungen kann eine Anordnung auf einem Trägermaterial 4 aus beispielsweise Glas, Beton oder Stahl bevorzugt sein. Elastische Materialien, die als Trägermaterial 4 in Frage kommen, können unter anderem Gummi, ein Kunststoff oder ein Textil, wie beispielsweise ein Baumwollgarn, sein.

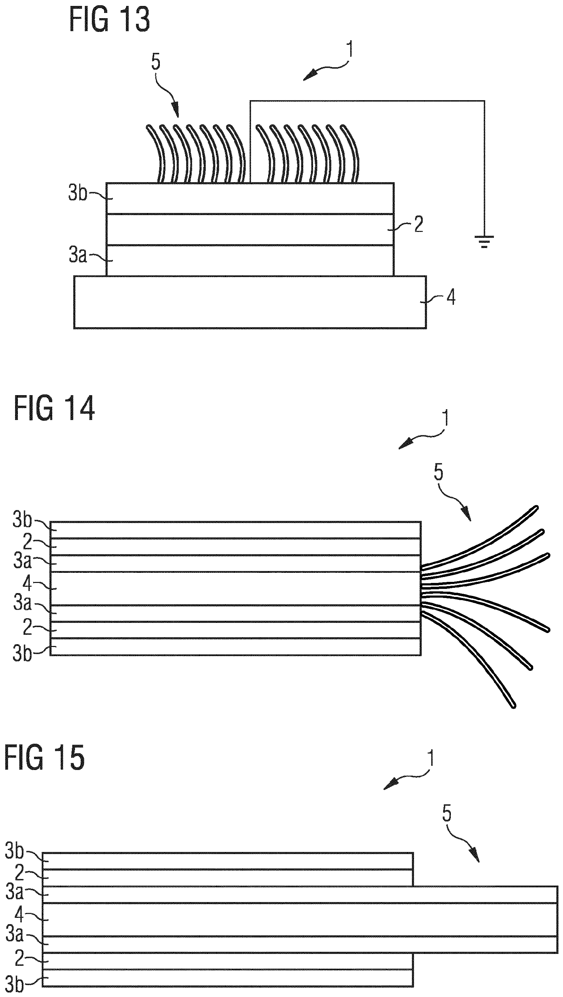

In Figur 13 wird eine schematische Querschnittsansicht eines Sensors 1, ähnlich zu Figur 1, gezeigt, wobei der Sensor 1 auf einem Trägermaterial 4 angeordnet ist und mechanische Verstärkerelemente 5 auf der zweiten Elektrode 3b aufweist. Die mechanischen Verstärkerelemente 5, die in Figur 13 als haar-, oder borstenförmige Vorsprünge dargestellt sind, können eine Berührung auf die zweite Elektrode 3b mechanisch übertragen. Diese Berührung wird, da die ferroelektrische Schicht 2 an der zweiten Elektrode 3b haftet, auch an die ferroelektrische Schicht 2 weitergegeben und verformt so die ferroelektrische Schicht 2. Dies vergrößert den Detektionsbereich, der mit dem piezoelektrischen Effekt abgedeckt werden kann. Die mechanischen Verstärkerelemente 5 sind entweder aus einem Verbundwerkstoff oder aus Kunstoffen wie PET, Duroplast oder Teflon.

Mechanische Verstärkerelemente 5 können ebenfalls auf zylindrischen Sensoren 1 und Sensoren 1, die auf keinem Trägermaterial 4 angeordnet sind, aufgebracht oder ausgebildet sein. Bevorzugt sind die Verstärkerelemente 5 in axialer Richtung als Verlängerung der ersten Elektrode 3a und/oder des Trägermaterials 4 angebracht, wie es in Figur 14 gezeigt wird. Bevorzugt wird das Verstärkerelement 5 hierbei nicht zusätzlich aufgebracht sondern durch die erste Elektrode 3a und das Trägermaterial 4 realisiert, wobei in einem Bereich, der als Verstärkerelement 5 dient, auf der ersten Elektrode 3a und dem Trägermaterial 4 keine weiteren ferroelektrischen Schichten 2 und keine weiteren zweiten Elektroden 3b aufgebracht sind. Eine Darstellung eines Querschnitts eines so ausgeführten Sensors ist in Figur 15 dargestellt. Zur zusätzlichen Signalverstärkung können derartige, mit Verstärkerelementen 5 versehene, zylindrische Sensoren 1 zu Büscheln aus mehreren einzelnen Sensoren 1 zusammengefasst werden.

Alternativ kann das Verstärkerelement 5 auch nur aus dem Trägermaterial 4 ausgebildet sein. In zylindrischen Ausführungsbeispiel, bei dem das Trägermaterial 4 im Inneren angeordnet ist, wird dann auch auf die ersten Elektroden 3a im Bereich des Verstärkerelements 5 verzichtet. Ist der Sensor 1 auf einem Trägermaterial 4 angeordnet, das ein größeres Ausmaß als der Sensor 1 selbst hat, wirkt der hervorragende Teil des Trägermaterials 4 auch als Verstärkerelement 5. In Ausführungsformen in denen kein Trägermaterial 4, sondern die erste Elektrode 3a, im Inneren angeordnet ist, kann das Verstärkerelement 5 auch nur aus der ersten Elektrode 3a ausgebildet sein. Dann ragt die erste Elektrode 3a aus dem Sensor 1 heraus, wobei auf eine ferroelektrische Schicht 2 und eine zweite Elektrode 3b verzichtet wird.

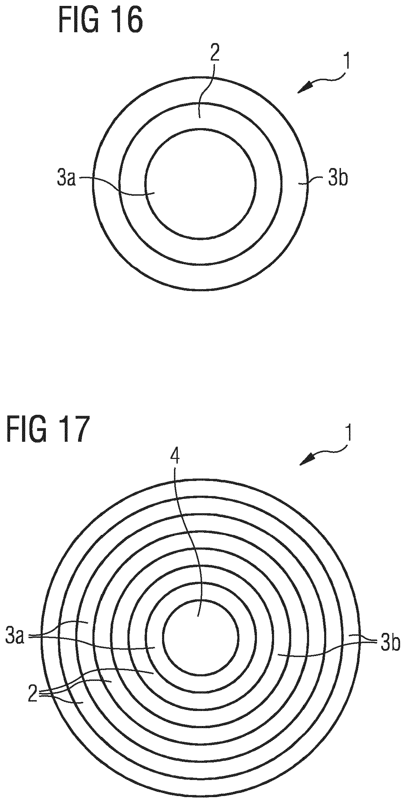

In Figur 16 wird eine schematische Querschnittsansicht eines zylindrisch ausgeführten Sensors 1 gezeigt. Im Inneren ist die erste Elektrode 3a angeordnet, die von einer pyroelektrischen Schicht 2 ummantelt wird. Die ferroelektrische Schicht 2 ist wiederrum von der zweiten Elektrode 3b ummantelt. Die zweite Elektrode 3a ist geerdet, wobei das in Figur 16 nicht dargestellt ist.

Bei der ersten Elektrode 3a kann es sich um einen handelsüblichen Draht handeln. Vorzugsweise ist die erste Elektrode 3a mit einem Durchmesser von etwa 150 µm bis 250 µm sehr dünn gehalten, um die thermische Masse des Sensors 1 zu reduzieren. Die ferroelektrische Schicht 2 ist aus denselben Grund mit einer Dicke von weniger als 5 µm dünn ausgeführt. Bei der zweiten, und in dieser Ausführungsform äußersten, Elektrode muss bei der Wahl der Dicke der Schicht zwischen der Sensitivität des Sensors 1 und des Schutzes der pyroelektrischen Schicht 2 abgewogen werden. In der Praxis wurde eine Dicke von etwa 10 µm als vorteilhafter Kompromiss gefunden.

Die zylinderförmige Form des Sensors 1 ist besonders vorteilhaft für Anwendungen, in denen der Sensor 1 in eine schmale Öffnung eingeführt werden soll. Außerdem ist eine zylindrische Geometrie des Sensors 1 hilfreich, um die Sensibilität gegenüber Verformungen zu erhöhen. Zusätzlich ermöglicht die zylindrische Ausführungsform den Sensor 1 in einem Endlosprozess, analog zur Draht bzw. Kabelfertigung, herzustellen. Dies vereinfacht die Herstellung und senkt die Produktionskosten.

In Figur 17 wird eine schematische Querschnittsansicht eines zylindrisch ausgeführten Sensors 1, ähnlich zu Figur 14, gezeigt. Im Inneren ist ein Trägermaterial 4 angeordnet. Jeweils zwei erste und zweite Elektroden 3a, 3b ummanteln alternierend das Trägermaterial 4, wobei jeweils eine ferroelektrische Schicht 2 zwischen den ersten und zweiten Elektroden 3a, 3b angeordnet ist. Die Schichten im Inneren des Sensors 1 sind auch im diesen Ausführungsbeispiel dünner als 5 µm. Die zweite Elektrode 3b, die die äußerste Schicht bildet, ist vorzugsweise 10 µm dick. Durch den Einsatz von mehreren pyroelektrischen Schichten 2 ist die Genauigkeit des Sensors 1 gegenüber einem Ausführungsbeispiels mit einer pyroelektrischen Schicht 2 erhöht.

Das Trägermaterial 4 kann beispielsweise eine Textilfaser, Glasfaser oder Faser-Bragg-Gitter sein. Wird eine Textilfaser als Trägermaterial 4 genutzt, kann dieser in Kleidungen, Bezügen, Teppichen und anderen Textilprodukten eingewebt werden. Textilfasern aus Kunststoff, etwa Polyester, eignen sich hervorragend als Trägermaterial 4. Naturfaser, aus Baumwolle zum Beispiel, können ebenfalls genutzt werden. Eine Glasfaser als Trägermaterial 4 kann für die Anzeige des Systemzustands, ob etwa eine unmittelbare Berührung oder einer Annäherung stattfindet, benutzt werden, indem Licht einer bestimmten Farbe durch die Glasfaser transmittiert wird. Der Einsatz von Faser-Bragg-Gittern als Trägermaterial 4 ist ebenfalls möglich. Diese können die Sensorik erweitern, indem sie beispielsweise als Kraftsensor genutzt werden. Allerdings ist hierbei zu beachten, dass dazu weitere optische Auswertegerätschaften nötig sind.

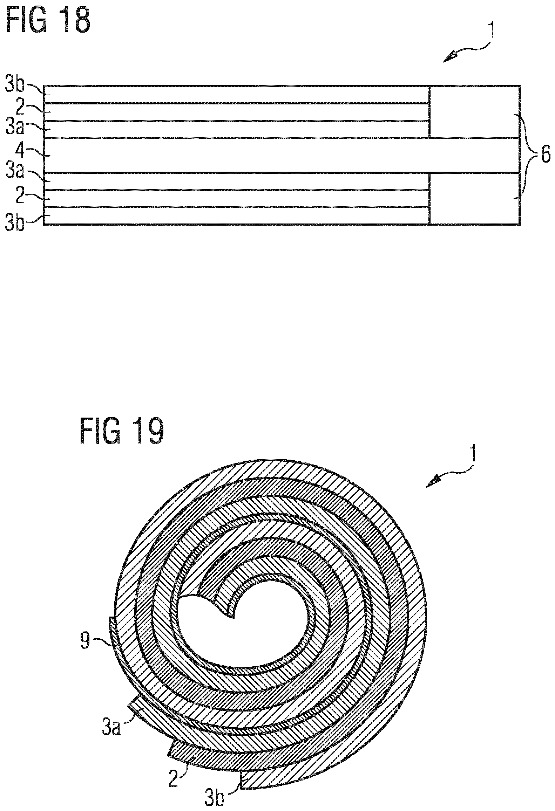

In Figur 18 wird eine längliche Querschnittsansicht eines zylindrisch ausgeführten Sensors 1 gezeigt. Im Inneren ist eine Glasfaser angeordnet, die von einer ersten und zweiten Elektrode 3a, 3b ummanteln wird, wobei eine ferroelektrische Schicht 2 zwischen der ersten und zweiten Elektroden 3a, 3b angeordnet ist. Auf einen Teil der Manteloberfläche der Glasfaser wurden keine erste und zweite Elektrode 3a, 3b sowie ferroelektrische Schicht 2 aufgebracht sondern stattdessen eine optisch reaktive Sensorschicht 6 aufgetragen. Diese optisch reaktive Schicht 6 kann zum Beispiel auf den ph-Wert oder O2-Gehalt in der Umgebung mit einer Farbänderung oder Fluoreszenzänderung reagieren. Mit Hilfe von evaneszenten Lichtwellen, die aus der Glasfaser austreten, kann diese Farbänderung gemessen werden. Auf diese Weise kann die Sensorik und das potentielle Anwendungsfeld für den Sensor 1 erweitert werden.

In Figur 19 wird eine schematische Querschnittsansicht eines Ausführungsbeispiels mit Isolationsschicht 9 dargestellt, wobei der Sensor 1 so aufgerollt ist, dass sich die Isolationsschicht 9 im Inneren befindet. Bei der Isolationsschicht handelt es sich um eine elektrisch isolierende flexible Schicht, die auch aus einem flexiblen und dünnen Trägermaterial 4 bestehen kann. Durch die Isolationsschicht 9 wird verhindert, dass die erste und zweite Elektrode 3a/3b beim Aufrollen kurz schließen.

Eine aufgerollte Ausführungsform ermöglicht es auch mit flächigen Herstellungsprozessen einen zylindrischen Sensor 1 herzustellen. Indem der Sensor 1 mehrmals aufgerollt wird, kann ein Vielschichtbauteil hergestellt werden, wobei zu beachten ist, dass die radial aufeinanderfolgenden Elektroden nicht wie beim ummantelten Sensor 1 elektrisch voneinander getrennt sind, sondern miteinander verbunden. Der aufgerollte Sensor 1 hat daher im Vergleich zu einem ummantelten Sensor 1 eine erhöhte Kapazität und der kapazitive Effekt ist ausgeprägter.

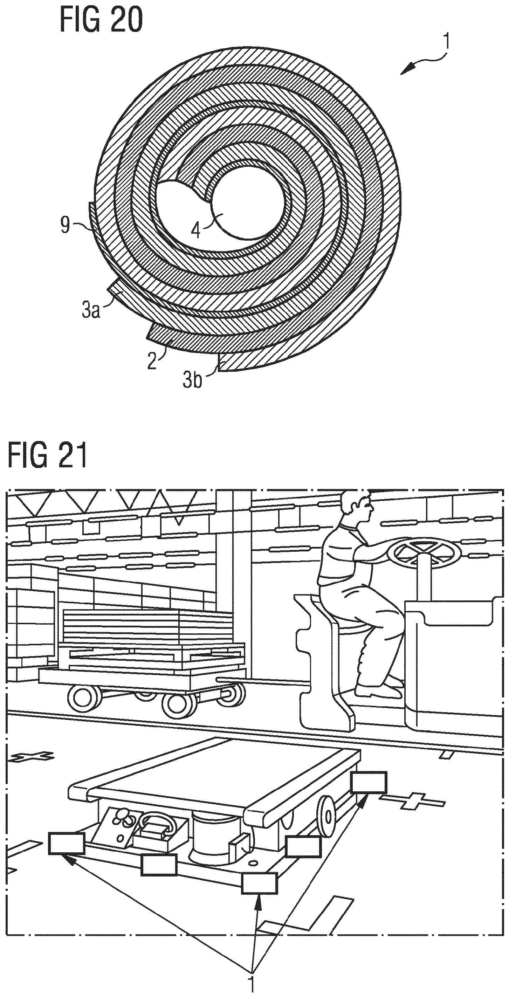

In Figur 20 wird analog zu Figur 19 eine schematische Querschnittsansicht eines Ausführungsbeispiels mit Isolationsschicht 9 gezeigt, wobei der Sensor 1 um ein Trägermaterial 4 aufgerollt ist. Mit Hilfe des Trägermaterials 4 können die mechanischen Eigenschaften des aufgerollten Sensor 1 beeinflusst werden.

Eine Kombination der unterschiedlichen Ausführungsformen ist ebenfalls möglich. So können beispielsweise ummantelte Sensoren 1 als Trägermaterial 4 dienen, wobei ein weiterer Sensor um dem ummantelten Sensor 1 aufgerollt wird. Somit kann der ausgeprägte kapazitive Effekt des aufgerollten Sensors 1 mit den Vorteilen eines ummantelten Sensors 1 verknüpft werden.

Alle Ausführungsbeispiele können weiterhin mit einer Schutzschicht, etwa aus Kunststoff, versehen sein, um den Sensor 1 gegenüber einer schädlichen Umgebung zu schützen.

In Figur 21 wird beispielhaft ein autonomer Transportroboter für Roboter im Allgemeinen gezeigt. Die Kästchen im unteren Bereich des Roboters zeigen vorteilhafte Positionen für das Anbringen eines Sensors 1 nach der vorliegenden Erfindung. Nähert sich der Roboter zum Beispiel einem Menschen wird bei einer Entfernung von einigen Metern eine Spannungsänderung an den Elektroden 3a, 3b des Sensors 1 auf Grund des pyroelektrischen Effekts festgestellt, und der Roboter kann als Folge beispielsweise seine Geschwindigkeit reduzieren. Nähert sich der Roboter weiterhin dem Menschen, wird ab einer Entfernung von etwa einem Meter eine Spannungsänderung, die wegen dem kapazitiven Effekt auftritt, festgestellt. Der Roboter könnte an dieser Stelle, auf Grund der Nähe zum Menschen, seine Bewegungsrichtung ändern. Kollidiert der Roboter nun trotzdem mit dem Menschen, so wird der Sensor 1 verformt und es wird eine Spannungsänderung infolge des piezoelektrischen Effekts detektiert. Nun könnte der Roboter, um keinen Schaden zu verursachen, stehen bleiben oder umkehren. Falls er stehen bleibt und die Verformung der ferroelektrischen Schicht sich deswegen nicht ändert, verschwindet die Spannungsänderung auf Grund des piezoelektrischen Effekts. Trotzdem kann die Berührung mit dem kapazitiven Effekt weiterhin detektiert werden.

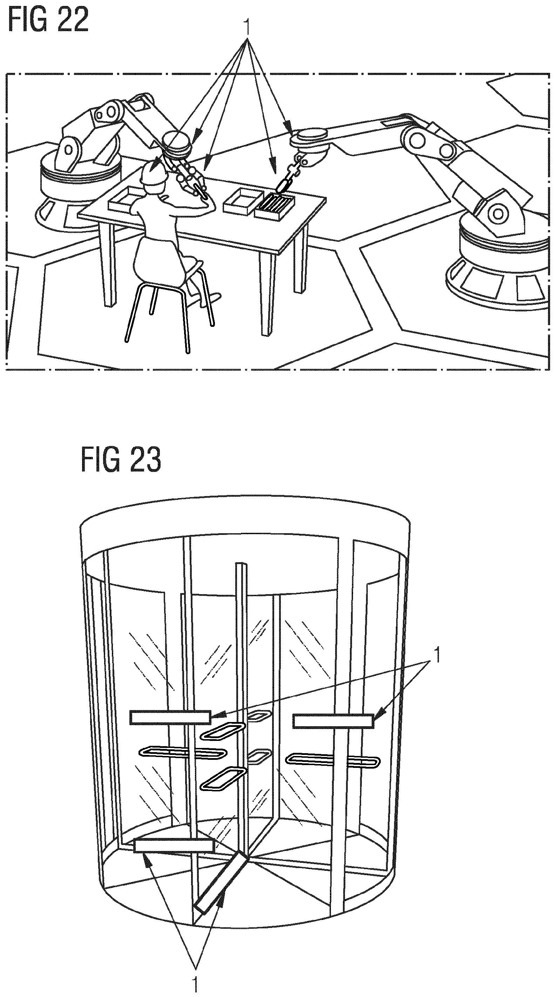

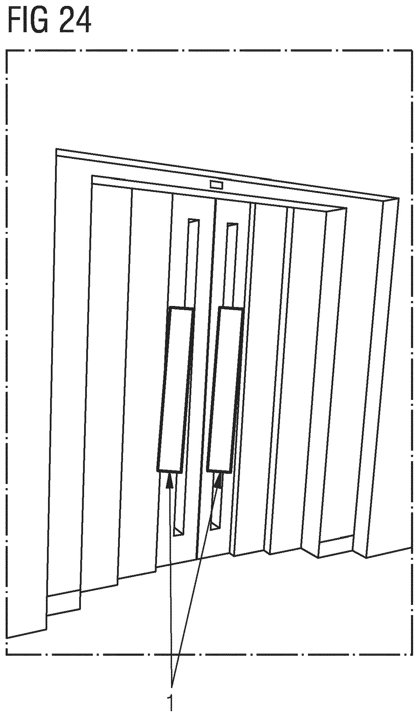

Figur 22 zeigt ein kollaboratives System, in welchem Sensoren 1 nach der vorliegenden 1 integriert sind. Insbesondere die Enden der Roboterarme, die einem mitarbeitenden Menschen besonders nahe kommen können, eignen sich für eine Positionierung der Sensoren 1. In Figur 23 und 24 werden die vorteilhaften Positionen für die Sensoren 1 an automatischen Türen gezeigt. Eine automatische Drehtür könnte bei einer Annäherung etwa ihre Drehgeschwindigkeit reduzieren und bei einer Berührung des Sensors 1 die Drehgeschwindigkeit wieder erhöhen. Ein automatische Fahrstuhltür, wie in Figur 24 gezeigt, könnte beispielsweise bereits bei einer Annäherung einer Person die Türe offen lassen. Infolgedessen kann im Vergleich zu den häufig benutzen Lichtschranken die Sicherheit erhöht werden, da die Sensoren bereits eine Annäherung einer Person an die Tür feststellen können und nicht erst reagieren, wenn diese Person bereits in der Tür steht.

### Bezugszeichenliste

- 1: Sensor
- 2: ferroelektrische Schicht
- 3a: erste Elektrode
- 3b: zweite Elektrode
- 4: Trägermaterial
- 5: mechanische Verstärkerelemente
- 6: optisch reaktive Schicht
- 7: Auswerteelektronik
- 8: digitale Auswertung
- 9: Isolationsschicht
- S: Signal

## Patentansprüche

1. Ein Sensor (1) aufweisend:
- eine erste Elektrode (3a),
- eine ferroelektrische Schicht (2),
- eine zweite Elektrode (3b),
wobei die zweite Elektrode (3b) mit Masse verbunden ist und die ferroelektrische Schicht (2) zwischen der ersten und zweiten Elektrode (3a, 3b) angeordnet ist,
wobei der Sensor (1) ein Trägermaterial (4) und eine Isolationsschicht (9) aufweist.

2. Sensor nach Anspruch 1,
wobei die erste Elektrode (3a) oder die zweite Elektrode (3b) auf der Isolationsschicht (9) angeordnet ist.

3. Sensor nach Anspruch 1 oder 2,
wobei die Isolationsschicht (9) auf dem Trägermaterial (4) angeordnet ist.

4. Sensor nach einem der vorangehenden Ansprüche,
wobei der Sensor (1) so aufgerollt ist, dass die Isolationsschicht (9) auf dem Trägermaterial (4) angeordnet ist.

5. Sensor (1) nach einem der vorangehenden Ansprüche,
wobei die ferroelektrischen Schicht (2) ein Polymer, eine Keramik oder eine Polymer-Keramik-Matrix aufweist.

6. Sensor (1) nach einem der vorangehenden Ansprüche,
wobei die ferroelektrische Schicht (2) eine blei-freie oder blei-haltige Keramik aufweist.

7. Sensor (1) nach Anspruch 5 oder 6,
wobei die Keramik PZT oder BaTiO₃ aufweist.

8. Sensor (1) nach Anspruch 7,
wobei die Keramik aufweisend PZT zusätzlich mit Na, Ca oder La dotiert ist.

9. Sensor (1) nach einem der Ansprüche 5 bis 8,
wobei die Keramik eine Dünnschicht aufweist.

10. Sensor (1) nach einem der vorherigen Ansprüche,
wobei die ferroelektrische Schicht (2) über ein Dünnschichtverfahren, beispielsweise CVD oder PVD, über eine Kombination aus einem Sol-Gel-Verfahren mit Spincoating, oder über Siebdruck auf der ersten Elektrode (3a) aufgetragen ist.

11. Sensor (1) nach einem der vorherigen Ansprüche,
ferner aufweisend eine Schutzschicht.

12. Sensor (1) nach einem der vorherigen Ansprüche,
wobei die erste und/oder die zweite Elektrode (3a, 3b) ein oder mehrere Metalle aufweisen, wobei das eine Metall oder die mehreren Metalle Al, Cr, Ni, Ag, Cu, Fe sowie eine Mischung oder einer Legierung dieser Elemente aufweisen.

13. Ein Sensor (1) nach einem der vorherigen Ansprüche, wobei die ferroelektrische Schicht (2) und/oder die ersten Elektroden (3a) und/oder zweiten Elektroden (3b) dünner als 50 µm sind.

14. Ein Sensor (1) nach einem der vorherigen Ansprüche, wobei der Sensor (1) weitere erste Elektroden (3a), zweite Elektroden (3b) und ferroelektrische Schichten (2) aufweist, und wobei die ferroelektrischen Schichten (2) zwischen den ersten und zweiten Elektroden (3a, 3b) angeordnet sind.

15. Ein Sensor (1) nach einem der vorherigen Ansprüche, wobei die ferroelektrischen Schichten (2) ein piezoelektrisches und/oder pyroelektrisches Material aufweisen.

16. Eine Anordnung, aufweisend:
- mindestens eine Auswerteelektronik (7),
- mindestens einen Sensor (1) nach einem der vorherigen Ansprüche,
wobei die Auswerteelektronik (7) dazu ausgestaltet ist, ein durch den Sensor (1) erzeugtes elektrisches Signal (S) zu messen und durch Änderungen des elektrischen Signals (S) einen piezoelektrischen Effekt, einen pyroelektrischen Effekt und einen kapazitiven Effekt zu erkennen.

17. Eine Anordnung nach dem vorherigen Anspruch,
wobei die Auswerteelektronik (7) dazu ausgestaltet ist, anhand der gemessenen Änderungen des elektrischen Signals zu erkennen, ob ein Objekt sich dem Sensor (1) nähert, oder ob ein Objekt den Sensor (1) berührt.

18. Eine Anordnung nach Anspruch 16 oder 17,
wobei die gemessenen Änderungen des elektrischen Signals (S) eine Änderung des Signal-Zeit-Verlauf und/oder der Amplitude und/oder der Zeitskala und/oder der zeitlichen Dynamik und/oder der Polarität umfassen.

19. Eine Anordnung nach einem der Ansprüche 16 bis 18,
wobei das elektrische Signal (S) eine Spannung und/oder eine Ladung und/oder eine Kapazität und/oder eine Polarität umfasst.

20. Eine Anordnung nach einem der Ansprüche 16 bis 19, ferner aufweisend:
- mehrere Sensoren (1) nach einem der Ansprüche 1 bis 15, wobei die Sensoren (1) in einer Matrix angeordnet sind.
